# EUROPEAN PATENT APPLICATION

(11) **EP 4 822 412 A1**
(43) Date of publication of application: **14.10.2026**
(21) Application number: 24910022.3
(22) Date of filing: 13.09.2024
(51) Int. Cl.: G02B 6/42

(54) **PACKAGING STRUCTURE, OPTICAL MODULE, AND OPTICAL COMMUNICATION SYSTEM**

(30) Priority: 27.12.2023 CN 202311820649
(71) Applicant: Huawei Technologies Co., Ltd., Shenzhen, Guangdong 518129 (CN)
(72) Inventor: DONG, Hao, Shenzhen, Guangdong 518129 (CN); SONG, Zhipeng, Shenzhen, Guangdong 518129 (CN); ZHANG, Shixuan, Shenzhen, Guangdong 518129 (CN); WAN, Yuan, Shenzhen, Guangdong 518129 (CN); ZHANG, Pengbo, Shenzhen, Guangdong 518129 (CN); PENG, Wanquan, Shenzhen, Guangdong 518129 (CN)
(74) Representative: Huawei European IPR
(86) International application number: PCT/CN2024/118871
(87) International publication number: WO 2025/139076

(57) **Abstract**

A package structure, an optical module, and an optical communication system are provided. The package structure includes: a ferrule (110), including an optical fiber (111), where the optical fiber (111) is configured to transmit signal light; a tube cap (120), including a lens (121), where the lens (121) is configured to focus the signal light; and a tube base (130), cooperating with the tube cap (120) to form an accommodation cavity, where an optical receiving chip (140) is disposed in the accommodation cavity, the optical receiving chip (140) is configured to receive the focused signal light, and an included angle between a normal line (141) of a plane on which the optical receiving chip (140) is located and a principal optical axis (122) of the lens (121) is greater than 0 degrees. In this way, the focused signal light received by the optical receiving chip (140) is reflected at a large angle at the optical receiving chip (140), so that most of the signal light reflected from the optical receiving chip (140) is emitted from an edge of the lens (121), and cannot be converged at the optical fiber (111). This improves a return loss capability of the package structure.

## Description

This application claims priority to Chinese Patent Application No. 202311820649.3, filed with the China National Intellectual Property Administration on December 27, 2023, and entitled "PACKAGE STRUCTURE, OPTICAL MODULE, AND OPTICAL COMMUNICATION SYSTEM".

### TECHNICAL FIELD

This application relates to the field of optical communication, and in particular, to a package structure, an optical module, and an optical communication system.

### BACKGROUND

Radio-over-fiber (radio-over-fiber, RoF) is a radio access technology combining optical fiber communication and wireless communication. In the RoF, an optical fiber is used as a transmission link between a base station and a central station. An electrical signal is modulated to signal light, and the signal light is transmitted through the optical fiber link. Finally, the signal light is demodulated to the electrical signal at the base station. Compared with a cable, the optical fiber has advantages such as a small size, a low loss, a wide bandwidth, a long transmission distance, and strong anti-electromagnetic interference. In addition, because switching, control, and the like of the signal light are centralized in the central station, a plurality of base stations may share the same central station, thereby reducing overall power consumption and costs of an RoF system. Therefore, the RoF is widely studied as an important signal transmission technology, and may be used as a favorable solution for an indoor 5th generation mobile communication technology (5th generation mobile communication technology, 5G) wireless small cell.

In the RoF system, an optical carrier carries an analog radio frequency signal. In comparison with a conventional digital optical fiber transmission link, the dispersion, nonlinear effect, and other factors of the optical fiber link affect an analog digital link. Therefore, an extremely high optical return loss requirement is imposed on an apparatus. An optical loss interferes with a transmission signal, and causes problems such as a measured insertion loss and a decrease in available optical power at a remote end. This directly affects an uplink/downlink connection and clock synchronization of the RoF, and even causes an optical fiber link failure in a severe case. Therefore, how to implement a receiving solution with a high optical return loss at a receive end in radio-over-fiber is an urgent problem to be resolved.

### SUMMARY

This application provides a package structure, an optical module, and an optical communication system. A solution in which an optical receiving chip is obliquely mounted is used, to form large-angle reflection on a reflective surface of the optical receiving chip, increase an aberration of a reflected light beam, and improve a return loss capability.

According to a first aspect, a package structure is provided, including: a ferrule, including an optical fiber, where the optical fiber is configured to transmit signal light; a tube cap, including a lens, where the lens is configured to focus the signal light; and a tube base, cooperating with the tube cap to form an accommodation cavity, where an optical receiving chip is disposed in the accommodation cavity, the optical receiving chip is configured to receive the focused signal light, and an included angle between a normal line of a plane on which the optical receiving chip is located and a principal optical axis of the lens is greater than 0 degrees. In the package structure of this application, the emitted signal light that is transmitted through the optical fiber directly enters the lens, and is emitted after being focused by the lens. The focused signal light is directly received by the optical receiving chip. Because the optical receiving chip is obliquely disposed in the accommodation cavity, the focused signal light received by the optical receiving chip is reflected at a large angle at the optical receiving chip, so that most of the signal light reflected from the optical receiving chip is emitted from an edge of the lens, and cannot be converged at the optical fiber. This improves a return loss capability of the package structure.

With reference to the first aspect, in some implementations of the first aspect, the included angle between the normal line and the principal optical axis is greater than or equal to 2 degrees and less than or equal to 25 degrees. In this way, a size of a receive light spot on the optical receiving chip can be ensured, so that the optical receiving chip can correctly identify the focused signal light, and it can also be ensured that large-angle reflection is formed on a reflection surface of the optical receiving chip, thereby increasing an aberration of a reflected light beam and improving a return loss capability.

In some implementations, when the lens is aspherical, the included angle between the normal line and the principal optical axis is greater than or equal to 6 degrees and less than or equal to 10 degrees. An object distance and a phase distance of the aspherical lens are close, and an angle relationship and a return loss relationship are consistent. At this angle, the return loss capability of the package structure can be ensured, and it can also be ensured that the optical receiving chip reaches a responsivity indicator.

In some implementations, when the lens is spherical, the included angle between the normal line and the principal optical axis is greater than or equal to 2 degrees and less than or equal to 8 degrees. The spherical lens has a large phase difference, and there is a difference between an angle relationship and a return loss relationship. At this angle, the return loss capability of the package structure can be ensured, and it can also be ensured that the optical receiving chip reaches a responsivity indicator.

With reference to the first aspect, in some implementations of the first aspect, an optical filter film is attached to an edge of the lens, and the optical filter is configured to absorb the signal light reflected from the optical receiving chip. In this way, light intensity of the signal light reflected from the optical receiving chip is reduced, and the return loss capability of the package structure is further improved. In some implementations, an optical filter is disposed between the lens and the optical receiving chip, and the optical filter is located on a reflection path of the signal light on the optical receiving chip. The attached optical filter film can reduce the light intensity of the signal light reflected from the optical receiving chip to the edge of the lens, and further improve the return loss capability of the package structure.

With reference to the first aspect, in some implementations of the first aspect, the optical receiving chip is mounted on a bearing module having an oblique surface. In this way, oblique mounting of the optical receiving chip is implemented.

With reference to the first aspect, in some implementations of the first aspect, a height of the bearing module is adjustable. The bearing module is configured to adjust a distance between the optical receiving chip and the lens, where the distance between the optical receiving chip and the lens is determined based on a focal length of the lens, to determine the size of the receive light spot on the optical receiving chip, and ensure that the optical receiving chip can correctly identify the focused signal light. The bearing module may be a gasket, a groove, a boss, or a column.

With reference to the first aspect, in some implementations of the first aspect, the optical fiber is located on the principal optical axis. In this way, an incident path of the signal light on the lens coincides with the principal optical axis, thereby improving efficiency of coupling between the optical fiber and the lens, and reducing the process difficulty of optical coupling and alignment.

With reference to the first aspect, in some implementations of the first aspect, an optical splitter is disposed between the ferrule and the lens, a center of the optical splitter is located on the principal optical axis, and an included angle between a straight line on which the optical fiber is located and the optical splitter is equal to an included angle between the optical splitter and the principal optical axis. In this way, an incident path of the signal light on the lens coincides with the principal optical axis, thereby improving efficiency of coupling between the optical fiber and the lens, and reducing the process difficulty of optical coupling and alignment.

With reference to the first aspect, in some implementations of the first aspect, an optical emitting chip is further included, where the optical emitting chip is disposed in the accommodation cavity; or the package structure further includes another tube base and another tube cap, the another tube base and the another tube cap cooperate to form another accommodation cavity, and the optical emitting chip is disposed in the another accommodation cavity. In this case, the package structure may be in a form of an optical transceiver assembly.

According to a second aspect, an optical module is provided, including a processor and the package structure according to the first aspect and any possible implementation. The package structure is configured to receive signal light, and convert the signal light into an electrical signal. The processor is configured to receive the electrical signal and obtain data.

With reference to the second aspect, in some implementations of the second aspect, the optical module further includes a light source and a driver.

According to a third aspect, an optical communication system is provided, including an electronic device and the optical module according to the second aspect and any possible implementation. The electronic device is connected to the optical module, and the electronic device is any one of a switch, an optical fiber router, or an optical fiber network adapter. The electronic device may include a plurality of ports, each of the plurality of ports corresponds to one optical transmission channel, and a port in the plurality of ports is connected to the optical module, to implement multi-channel and high-rate data transmission.

According to a fourth aspect, an optical module is provided, including a light source, a driver, a processor, and the package structure in an optical transceiver form according to the first aspect. The light source is configured to emit a light beam. The driver is configured to send an electrical signal, where the electrical signal carries data. The driver is connected to the optical emitting chip, and the optical emitting chip modulates the light beam based on the electrical signal, to send signal light. The driver may be in a form of a driver chip. The optical receiving chip is configured to receive other signal light, and convert the other signal light into another electrical signal. The processor is configured to receive the electrical signal and obtain the data.

### BRIEF DESCRIPTION OF DRAWINGS

FIG. 1 is a diagram of a package structure according to an embodiment of this application;
FIG. 2 is a diagram of another package structure according to an embodiment of this application;
FIG. 3A and FIG. 3B are diagrams of an optical path in a package structure according to an embodiment of this application;
FIG. 4A and FIG. 4B are diagrams of mounting an optical receiving chip according to an embodiment of this application;
FIG. 5 is a diagram of a method for determining a distance between an optical receiving chip and a lens according to an embodiment of this application;
FIG. 6A to FIG. 6C are diagrams of an optical coupling structure and an optical return loss structure of a package structure according to an embodiment of this application;
FIG. 7A to FIG. 7C are diagrams of an optical coupling structure and an optical return loss structure of a package structure according to an embodiment of this application;
FIG. 8 is a diagram of an optical path in another package structure according to an embodiment of this application;
FIG. 9 shows an optical module according to an embodiment of this application;
FIG. 10 shows another optical module according to an embodiment of this application; and
FIG. 11 is a diagram of an optical communication system according to an embodiment of this application.

### DESCRIPTION OF EMBODIMENTS

The following describes technical solutions of this application with reference to accompanying drawings.

The terms "first" and "second" mentioned below are merely intended for a purpose of description, and shall not be understood as an indication or implication of relative importance or implicit indication of the number of indicated technical features. Therefore, a feature limited by "first" or "second" may explicitly or implicitly include one or more features.

Reference to "an embodiment", "some embodiments", or the like described in this specification means that a specific feature, structure, or characteristic described with reference to the embodiment is included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "contain", "have", and their variants all mean "include but are not limited to", unless otherwise specifically emphasized.

In the descriptions of embodiments of this application, orientations or position relationships indicated by terms "up", "down", "vertical", "horizontal", and the like are defined relative to orientations or positions in which parts are schematically placed in the accompanying drawings. It should be understood that these directional terms are relative concepts, and are used for relative description and clarification, but do not indicate or imply that a specified apparatus or component needs to have a specific orientation or be constructed and operated in a specific orientation. These directional terms may vary correspondingly based on changes of positions of the parts in the accompanying drawings, and therefore cannot be understood as a limitation on this application.

In the following embodiments of this application, the terms such as "include", "have", and any variants thereof are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

In embodiments of this application, terms such as "example" or "for example" are used to represent giving an example, an illustration, or a description. Any embodiment or design scheme described with "example" or "for example" should not be explained as being more preferred or having more advantages than another embodiment or design scheme. Use of the terms such as "example" or "for example" is intended to present a related concept in a specific manner for ease of understanding.

In embodiments of this application, a same reference numeral indicates a same component or a same part. In addition, parts in the accompanying drawings are not drawn based on an actual scale. Dimensions and sizes of the parts shown in the figures are merely examples, and should not be understood as a limitation on this application.

Radio-over-fiber (radio-over-fiber, RoF) is a radio access technology combining optical fiber communication and wireless communication. In the RoF, an optical fiber is used as a transmission link between a base station and a central station. An electrical signal is modulated to signal light, and the signal light is transmitted through the optical fiber link. Finally, the signal light is demodulated to the electrical signal at the base station. Compared with a cable, the optical fiber has advantages such as a small size, a low loss, a wide bandwidth, a long transmission distance, and strong anti-electromagnetic interference. In addition, because switching, control, and the like of the signal light are centralized in the central station, a plurality of base stations may share the same central station, thereby reducing overall power consumption and costs of an RoF system. Therefore, the RoF is widely studied as an important signal transmission technology, and may be used as a favorable solution for an indoor 5th generation mobile communication technology (5th generation mobile communication technology, 5G) wireless small cell.

In the RoF system, an optical carrier carries an analog radio frequency signal. In comparison with a conventional digital optical fiber transmission link, the dispersion, nonlinear effect, and other factors of the optical fiber link affect an analog digital link. Therefore, an extremely high optical return loss requirement is imposed on an apparatus. The optical return loss may also be referred to as an optical echo loss or an optical reflection loss, and is a loss caused by reflection between an optical fiber interface, a connection, and a channel when signals are transmitted through an optical fiber. An optical loss interferes with a transmission signal, and causes problems such as a measured insertion loss and a decrease in available optical power at a remote end. This directly affects an uplink/downlink connection and clock synchronization of the RoF, and even causes an optical fiber link failure in a severe case. Therefore, how to implement a receiving solution with a high optical return loss at a receive end in radio-over-fiber is an urgent problem to be resolved.

In view of this, this application provides a package structure, an optical module, and an optical communication system. A solution in which an optical receiving chip is obliquely mounted is used, to form large-angle reflection on a reflective surface of the optical receiving chip, increase an aberration of a reflected light beam, and improve a return loss capability.

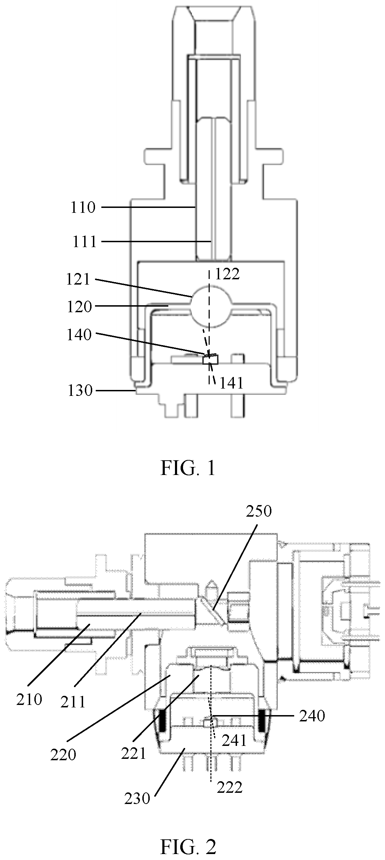

FIG. 1 is a diagram of a package structure according to an embodiment of this application. As shown in FIG. 1, the package structure may include a ferrule 110, an optical fiber 111, a tube cap 120, a lens 121, a tube base 130, and an optical receiving chip 140.

The ferrule 110 includes the optical fiber 111, and the optical fiber 111 is configured to transmit signal light. The ferrule 110 shown in FIG. 1 is of a cylindrical structure with a micro hole disposed in a center, and is configured to fasten a position of the optical fiber 111, to implement precise alignment between the optical fiber and another device, for example, the lens 121 or the optical receiving chip 140. In addition, the ferrule may also be referred to as an optical fiber connector. Composition of the ferrule, a mechanical fastener configured to fasten the ferrule, and the lens may also be referred to as an optical fiber adapter. The ferrule may alternatively be of a structure other than a cylinder. This is not limited in this application. In addition, alternatively, the optical fiber 111 may be specifically an optical fiber pigtail.

The tube cap 120 includes the lens 121, and the lens 121 is configured to focus the signal light. The lens 121 may be specifically a spherical lens, an aspherical lens, or the like, and is determined according to an actual situation. A principal optical axis 122 of the lens 121 may be perpendicular to a bearing surface of the tube base 130. The principal optical axis 122 of the lens 121 may be a straight line that passes through a center (or may be understood as an optical center) of the lens 121 and that is perpendicular to the lens. Alternatively, the principal optical axis 122 may be understood as a straight line that passes through a center of an upper surface of the lens 121 and a center of a lower surface of the lens 122. When the upper surface or the lower surface of the lens 121 is a sphere, the center may refer to a sphere center. The principal optical axis of the lens may also be referred to as a principal axis of the lens for short.

The tube base 130 cooperates with the tube cap 120 to form an accommodation cavity. The optical receiving chip 140 is disposed in the accommodation cavity, and the optical receiving chip 140 is configured to receive the focused signal light and convert the signal light into an electrical signal. There is an included angle greater than 0 degrees between a normal line 141 of a plane on which the optical receiving chip 140 is located and the principal optical axis 122 of the lens 121. Alternatively, it may be understood that the plane on which the optical receiving chip 140 is located intersects with the bearing surface of the tube base 130, the optical receiving chip 140 is not parallel to the bearing surface of the tube base 130, or the optical receiving chip 140 is obliquely disposed in the accommodation cavity. A center of the optical receiving chip 140 may be located on the principal optical axis 122.

In the package structure shown in FIG. 1, the emitted signal light that is transmitted through the optical fiber 111 directly enters the lens 121, and is emitted after being focused by the lens 121. The focused signal light is directly received by the optical receiving chip 140. Because the optical receiving chip 140 is obliquely disposed in the accommodation cavity, the focused signal light received by the optical receiving chip 140 is reflected at a large angle at the optical receiving chip 140, so that most of the signal light reflected from the optical receiving chip is emitted from an edge of the lens 121, and cannot be converged at the optical fiber 111. This improves a return loss capability of the package structure.

FIG. 2 is a diagram of another package structure according to an embodiment of this application. As shown in FIG. 2, the package structure may include a ferrule 210, an optical fiber 211, a tube cap 220, a lens 221, a tube base 230, an optical receiving chip 240, and an optical splitter 250.

The ferrule 210, the optical fiber 211, the tube cap 220, the lens 221, the tube base 230, and the optical receiving chip 240 are similar to the ferrule 110, the optical fiber 111, the tube cap 120, the lens 121, the tube base 130, and the optical receiving chip 140 in FIG. 1, and details are not described herein again. Similar to that in FIG. 1, there is an included angle greater than 0 degrees between a normal line 241 of a plane on which the optical receiving chip 240 is located and the principal optical axis 222 of the lens 221.

The optical splitter 250 is disposed between the optical fiber 211 and the lens 221 that is included in the tube cap 220. The optical splitter 250 is configured to reflect the emitted signal light that is transmitted through the optical fiber 111, so that the signal light enters the lens 221 and is emitted after being focused by the lens 221. The focused signal light is directly received by the optical receiving chip 240. Because the optical receiving chip 240 is obliquely disposed in the accommodation cavity, the focused signal light received by the optical receiving chip 240 is reflected at a large angle at the optical receiving chip 240, so that most of the signal light reflected from the optical receiving chip is emitted from an edge of the lens 221, and only a small part of the signal light is reflected back to the optical fiber 211 by the optical splitter 250. In this way, the signal light reflected from the optical receiving chip 240 cannot be converged again at the optical fiber 211, thereby improving a return loss capability of the package structure.

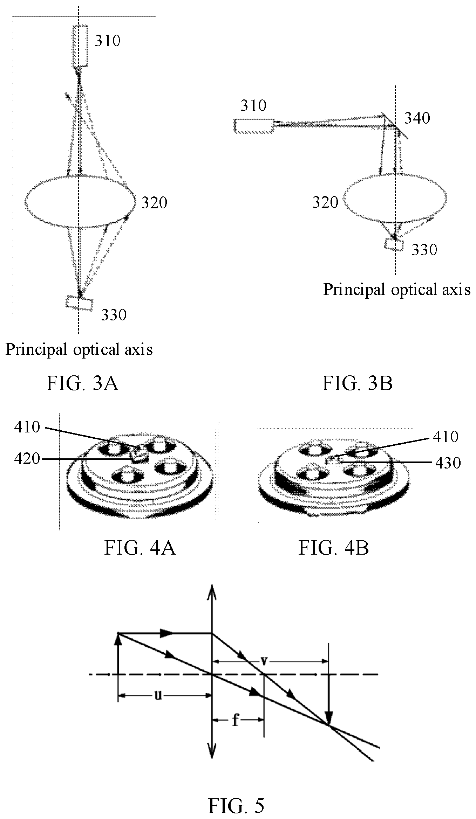

FIG. 3A and FIG. 3B are diagrams of an optical path in a package structure according to an embodiment of this application. In the package structures shown in FIG. 1 and FIG. 2, an incident path of the signal light on the lens coincides with the principal optical axis. In this way, efficiency of coupling between the optical fiber and the lens is improved, and the process difficulty of optical coupling and alignment is reduced. When a high return loss of the signal light reflected from the optical receiving chip in the package structure is ensured, efficiency of coupling performed when the signal light is incident from the lens in the package structure is further improved.

In an implementation, as shown in FIG. 3A, an optical fiber 310, a lens 320, and an optical receiving chip 330 are sequentially arranged along a principal optical axis of the lens 320, the optical fiber 310 is located on the principal optical axis, and a light outlet of the optical fiber 310 is aligned with a center of the lens 320. In this way, efficiency of coupling between the optical fiber and the lens is improved, and the process difficulty of optical coupling and alignment is reduced. An optical path shown in FIG. 3A is applicable to the package structure shown in FIG. 1.

In another implementation, as shown in FIG. 3B, the optical fiber 310, an optical splitter 340, the lens 320, and the optical receiving chip 330 are sequentially arranged along a transmission path of the signal light. An included angle between a straight line on which the optical fiber 310 is located and the optical splitter 340 is equal to an included angle between the optical splitter 340 and the principal optical axis of the lens 320, so that an incident path of the signal light on the lens coincides with the principal optical axis. In this way, efficiency of coupling between the optical fiber and the lens is improved, and the process difficulty of optical coupling and alignment is reduced. An optical path shown in FIG. 3B is applicable to the package structure shown in FIG. 2. In a case shown in FIG. 3B, a center of the optical fiber 310 is aligned with a center of the optical splitter 340, a center of the lens 320 is aligned with the center of the optical splitter 340, the included angle between the straight line on which the optical fiber 310 is located and the optical splitter 340 is 45 degrees, and the included angle between the optical splitter 340 and the principal optical axis of the lens 320 is 45 degrees. In addition, based on a specific design of the package structure, a specific included angle may be another degree. In addition, that angles are the same in this application may alternatively be understood as that a difference between two included angles is less than 1 degree.

In addition, in the package structure provided in this application, optical elements such as one or more prisms or a plurality of optical splitters may be further disposed between the optical fiber and the lens, so that the incident path of the signal light on the lens coincides with the principal optical axis. This is not limited in this application.

FIG. 4A and FIG. 4B are diagrams of mounting an optical receiving chip according to an embodiment of this application. In some implementations, the optical receiving chip is mounted on a bearing module having an oblique surface, and the bearing module may be specifically a gasket, a groove, a boss, or a column. As shown in FIG. 4A, the optical receiving chip 410 may be mounted on a gasket 420 having an oblique surface. As shown in FIG. 4B, the optical receiving chip 410 may be mounted in a groove 430 having an oblique surface. In addition, the optical receiving chip may alternatively be mounted on a boss or a column having an oblique surface. This is not limited in this application.

In some implementations, a height of the bearing module is adjustable. The bearing module is configured to adjust a distance between the optical receiving chip and the lens, where the distance between the optical receiving chip and the lens is determined based on a focal length of the lens, to determine a size of a receive light spot on the optical receiving chip, and ensure that the optical receiving chip can correctly identify the focused signal light.

FIG. 5 is a diagram of a method for determining the distance between the optical receiving chip and the lens according to an embodiment of this application. A geometric optical lens imaging formula is 1/f=1/u+1/v. Herein, f is a focal length, u is an object distance, and v is an image distance. The focal length f may be determined based on a specific lens model. The object distance u may be determined based on a position of a light outlet point of the signal light. For example, the position of the light outlet point in FIG. 1 may be understood as a position of a light outlet of the optical fiber, or the position of the light outlet point in FIG. 2 may be understood as a reflection position of the signal light in the optical splitter. After the signal light is emitted from the light outlet point, the signal light has a divergence. After the object distance f and the object distance u are determined, the phase distance v may be determined based on an incident direction of the signal light on the lens. Therefore, the distance between the optical receiving chip and the lens is determined based on the phase distance v, a corresponding bearing module is disposed on the tube base, the optical receiving chip is obliquely mounted on the bearing module, and the tube cap including the lens is welded on the tube base.

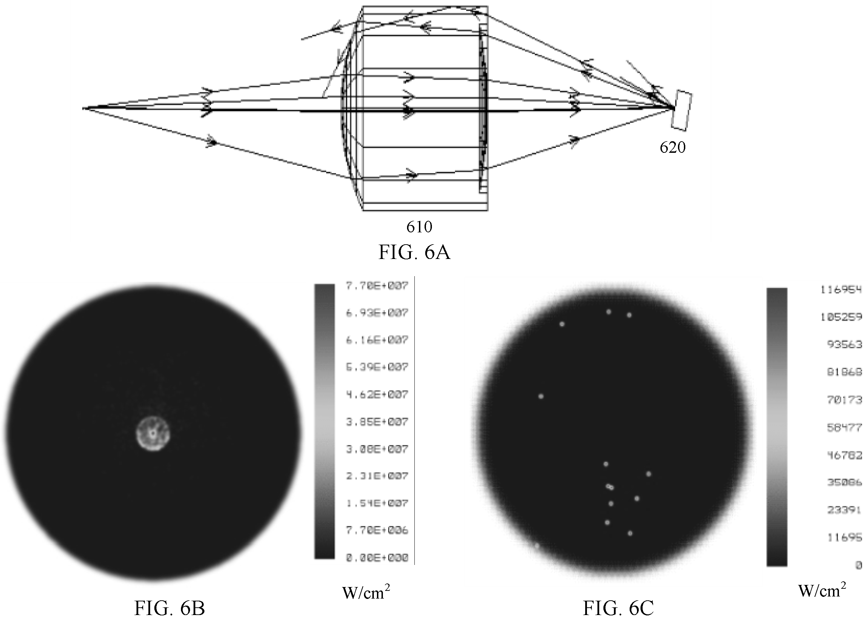

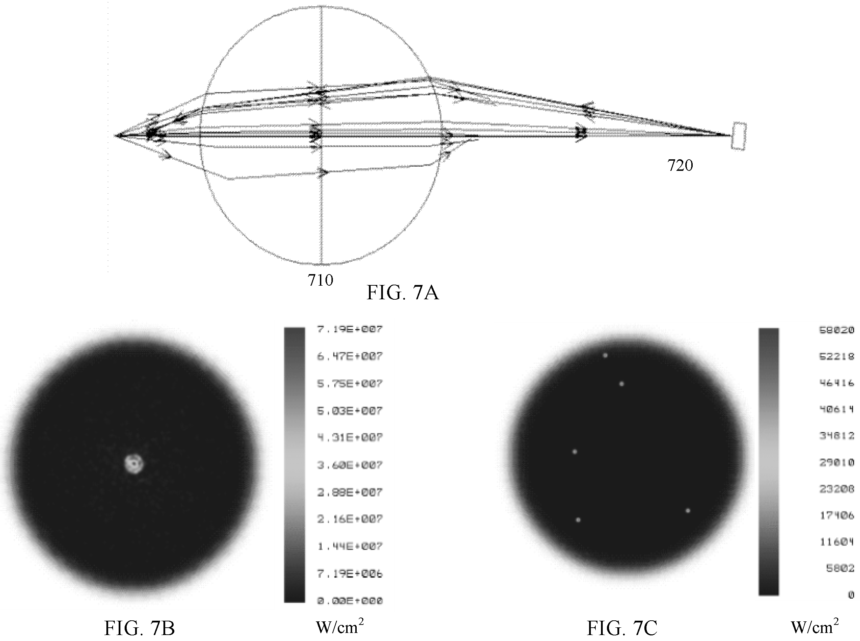

In some implementations, in the package structure in this application, the included angle between the normal line of the plane on which the optical receiving chip is located and the principal optical axis is greater than or equal to 2 degrees and less than or equal to 25 degrees. In this way, the size of the receive light spot on the optical receiving chip can be ensured, so that the optical receiving chip can correctly identify the focused signal light, and it can also be ensured that large-angle reflection is formed on a reflection surface of the optical receiving chip, thereby increasing an aberration of a reflected light beam and improving a return loss capability. With reference to FIG. 6A to FIG. 6C and FIG. 7A to FIG. 7C, the following specifically describes two cases in which the lens is aspherical and spherical.

FIG. 6A to FIG. 6C are diagrams of an optical coupling structure and an optical return loss structure of a package structure according to an embodiment of this application. As shown in FIG. 6A, an optical fiber (simplified as a dot in the figure), a lens 610, and an optical receiving chip 620 are sequentially arranged along a principal optical axis of the lens 610, and the lens 610 is an aspherical lens. Based on a change of an included angle θ between a normal line of a plane on which the optical receiving chip 620 is located and the principal optical axis of the lens 610, a corresponding return loss of the package structure is shown in Table 1.

**Table 1**

| θ (°) | Return loss (dB) |
|---|---|
| 0 to 2 | ~15 |
| 2 to 4 | ~18 |
| 4 to 6 | ~23 |
| 6 to 8 | ~32 |
| 8 to 10 | ~45 |

As shown in Table 1, when θ is 6 to 10 degrees, a return loss capability of the package structure reaches more than 30 dB, meeting a requirement of an RoF system for a high-return-loss package structure. When θ is 8 to 10 degrees, the return loss capability of the package structure reaches more than 45 dB, and the return loss capability of the package structure is greatly improved.

FIG. 6B shows a light spot of focused signal light received by the optical receiving chip when θ is 10 degrees and energy of signal light emitted from the optical fiber is 1 W. As shown in FIG. 6A, on a circular photosensitive surface with a diameter of 20 µm in the optical receiving chip, a received optical power is about 0.93 W, and optical coupling efficiency of the package structure is about 93%.

FIG. 6C shows energy distribution of light reflected from the optical receiving chip back to a light outlet of the optical fiber when θ is 10 and energy of signal light emitted from the optical fiber is 1 W. The light outlet of the optical fiber is a 9 µm circle, energy at the light outlet is about 7×10⁻⁵ W, and a return loss of the package structure reaches -41.5 dB.

When the lens is aspherical, an object distance and a phase distance of the lens are close, and an angle relationship and a return loss relationship are consistent. When the included angle between the normal line of the lens and the principal optical axis is greater than or equal to 6 degrees and less than or equal to 10 degrees, a return loss capability of the package structure can be ensured, and it can also be ensured that the optical receiving chip reaches a responsivity indicator.

FIG. 7A to FIG. 7C are diagrams of an optical coupling structure and an optical return loss structure of a package structure according to an embodiment of this application. As shown in FIG. 7A, an optical fiber (simplified as a dot in the figure), a lens 710, and an optical receiving chip 720 are sequentially arranged along a principal optical axis of the lens 710, and the lens 710 is a spherical lens. Based on a change of an included angle θ between a normal line of a plane on which the optical receiving chip 720 is located and the principal optical axis of the lens 710, a corresponding return loss of the package structure is shown in Table 2.

**Table 2**

| θ (°) | Return loss (dB) |
|---|---|
| 0 to 2 | ~20 |
| 2 to 4 | ~35 |
| 4 to 6 | ~45 |
| 6 to 8 | ~55 |

As shown in Table 2, when θ is 2 to 4 degrees, a return loss capability of the package structure reaches more than 30 dB, meeting a requirement of an RoF system for a high-return-loss package structure. When θ is 4 to 6 degrees, the return loss capability of the package structure reaches more than 45 dB, and the return loss capability of the package structure is greatly improved. When θ is 6 to 8 degrees, the return loss capability of the package structure can reach more than 55 dB.

FIG. 7B shows a light spot of focused signal light received by the optical receiving chip. FIG. 7C shows energy distribution of light reflected from the optical receiving chip back to a light outlet of the optical fiber.

The spherical lens has a large phase difference, and there is a difference between an angle relationship and a return loss relationship. When the included angle between the normal line of the lens and the principal optical axis is greater than or equal to 2 degrees and less than or equal to 8 degrees, a return loss capability of the package structure can be ensured, and it can also be ensured that the optical receiving chip reaches a responsivity indicator.

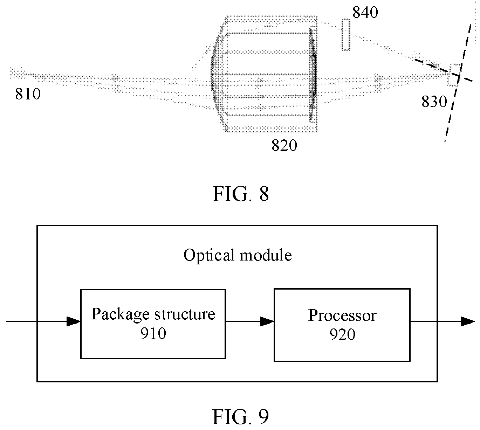

FIG. 8 is a diagram of an optical path in another package structure according to an embodiment of this application. As shown in FIG. 8, an optical filter 840 may be disposed between a lens 820 and an optical receiving chip 830, and the optical filter 840 may be located on a reflection path of signal light on the optical receiving chip 830. Alternatively, the optical filter 840 may be located on a normal line of a plane on which the optical receiving chip 830 is located. The optical filter is configured to absorb the signal light reflected from the optical receiving chip. In this way, light intensity of the signal light reflected from the optical receiving chip is reduced, and a return loss capability of the package structure is further improved. The optical filter may be specifically optical filter glass, a light filter, or the like. This is not limited in this application.

In some implementations, an optical filter film may alternatively be attached to an edge of the lens 820. The attached optical filter film can reduce the light intensity of the signal light reflected from the optical receiving chip 830 to the edge of the lens, and further improve the return loss capability of the package structure. That the optical filter film is attached to the edge of the lens may specifically mean that the optical filter film is attached to an edge on a surface that is of the lens 820 and that is adjacent to the optical fiber 810, and/or the optical filter film is attached to an edge on a surface that is of the lens and that is adjacent to the optical receiving chip 830. A material of the optical filter film may be Cr₂O₃ or the like, which is determined based on an actual situation. This is not limited in this application.

The package structure shown in FIG. 1 or FIG. 2 may further include an optical emitting chip. In some implementations, the optical emitting chip and the optical receiving chip may be disposed in a same accommodation cavity. In some implementations, the package structure further includes another tube base and another tube cap, the another tube base and the another tube cap cooperate to form another accommodation cavity, and the optical emitting chip is disposed in the another accommodation cavity.

In some implementations, the package structure may include only one optical receiving chip, and the package structure is an optical receiving device in a single-receive mode.

In some implementations, the package structure further includes one or more optical receiving chips, and the package structure is an optical receiving device in a one-transmit one-receive mode or a multi-receive mode.

In some implementations, the package structure further includes one or more optical receiving chips, and the package structure is an optical receiving device in a multi-receive mode.

In some implementations, the package structure further includes one or more optical emitting chips and one or more optical receiving chips, and the package structure is an optical transceiver in a multi-transmit multi-receive mode.

The optical receiving chip in this application may be any chip that receives signal light and converts the signal light into an electrical signal. For example, the optical receiving chip may be a photodiode (photodiode, PD) chip, a photomultiplier tube chip, an avalanche photodiode (avalanche photodiode, APD) chip, or the like. This is not limited in this application. The optical emitting chip in this application may be any chip that receives an electrical signal, converts the electrical signal into signal light, and sends the signal light. For example, the optical emitting chip may be a vertical cavity surface emitting laser chip, a Fabry-Perot laser chip, a horizontal cavity surface emitting laser chip, an electro-absorption modulation chip, or a distributed feedback chip. This is not limited in this application.

In addition, the package structure may further include an amplifier chip, and the amplifier chip and the optical receiving chip may be disposed in the same accommodation cavity. The amplifier chip is configured to amplify the electrical signal obtained by the optical receiving chip through conversion. The amplifier chip may be a trans-impedance amplifier chip, an amplitude limiting amplifier chip, an automatic gain amplifier chip, or the like. This is not limited in this application.

The optical emitting chip and the optical receiving chip may be mounted in an active mounting manner or a passive mounting manner. The active mounting may be understood as that the package structure includes an optical element having an active function, for example, an optical modulator. Through active coupling, a plurality of light beams may be integrated in different dimensions, that is, the overall package is externally represented as a single-beam optical path element including different optical signals. The passive mounting may be understood as that the package structure includes only optical elements having passive functions, for example, an optical isolator, a splitter, and an optical switch. Through passive mounting, a plurality of light beams may be integrated in different dimensions, that is, the overall package is externally represented as a single-beam optical path element including different optical signals.

It should be understood that the package structure shown in FIG. 1 and the package structure shown in FIG. 2 show only a form of an optical receiving assembly (transmitter optical subassembly, TOSA) and a form of an optical transceiver assembly (bidirectional optical sub-assembly, BOSA). In addition, the package structure provided in this application is also applicable to, for example, a triplexer (Triplexer) optical transceiver assembly, a quadrature multiplexer optical transceiver assembly (Quad-optical sub-assembly, Quad-OSA), and the like. A specific package form is not limited in this application.

FIG. 9 shows an optical module according to an embodiment of this application. As shown in FIG. 9, the optical module includes a package structure 910 and a processor 920. The package structure 910 may be the package structure shown in FIG. 1 to FIG. 7C. The package structure is configured to receive signal light, and convert the signal light into an electrical signal. The processor 920 is configured to receive the electrical signal and obtain data. The processor 920 may be in a form of a processing chip.

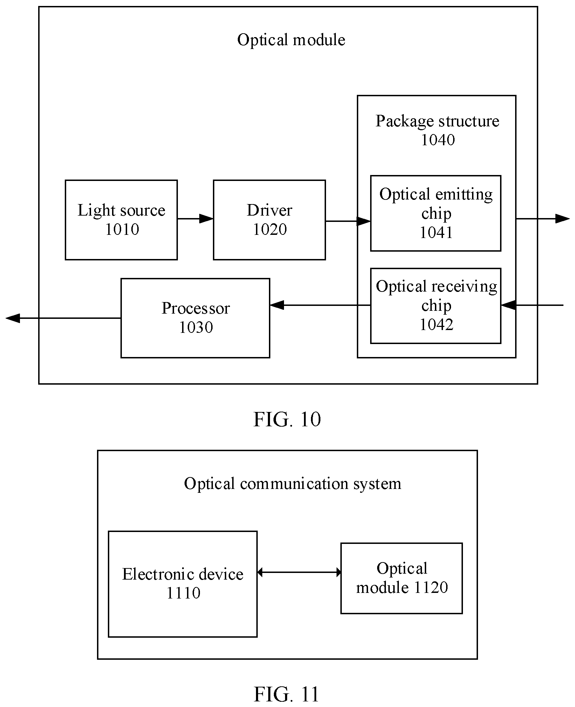

FIG. 10 shows another optical module according to an embodiment of this application. As shown in FIG. 10, the optical module includes a light source 1010, a driver 1020, a processor 1030, and a package structure 1040. The package structure 1010 may be the package structure shown in FIG. 1 to FIG. 7C, and the package structure 1010 includes an optical emitting chip 1041 and an optical receiving chip 1042.

The light source 1010 is configured to emit a light beam. The driver 1020 is configured to send an electrical signal, where the electrical signal carries data. The driver 1020 is connected to the optical emitting chip 1041, and the optical emitting chip 1011 modulates the light beam based on the electrical signal, to send signal light. The driver 1020 may be in a form of a driver chip.

The optical receiving chip 1042 is configured to receive other signal light, and convert the other signal light into another electrical signal. The processor 1030 is configured to receive the electrical signal and obtain the data. The processor 1030 may be in a form of a processing chip.

FIG. 11 is a diagram of an optical communication system according to an embodiment of this application. As shown in FIG. 11, the optical communication system may include an electronic device 1110 and the optical module shown in FIG. 9 or FIG. 10. The electronic device 1110 may be any one of a switch, an optical fiber router, or an optical fiber network adapter, and the electronic device is connected to the optical module.

The electronic device 1110 may include a plurality of ports, each of the plurality of ports corresponds to one optical transmission channel, and a port in the plurality of ports is connected to the optical module, to implement multi-channel and high-rate data transmission. The switch may be configured to implement data exchange between a plurality of transmission channels. The optical fiber router may be configured to convert an optical signal into a data signal, and implement forwarding and route selection of the data signal. The optical fiber network adapter may be used in an Ethernet network to implement a connection between a computer and an optical fiber.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A package structure, comprising:
a ferrule, comprising an optical fiber, wherein the optical fiber is configured to transmit signal light;
a tube cap, comprising a lens, wherein the lens is configured to focus the signal light; and
a tube base, cooperating with the tube cap to form an accommodation cavity, wherein an optical receiving chip is disposed in the accommodation cavity, the optical receiving chip is configured to receive the focused signal light, and an included angle between a normal line of a plane on which the optical receiving chip is located and a principal optical axis of the lens is greater than 0 degrees.

2. The package structure according to claim 1, wherein the included angle between the normal line and the principal optical axis is greater than or equal to 2 degrees and less than or equal to 25 degrees.

3. The package structure according to claim 2, wherein when the lens is aspherical, the included angle between the normal line and the principal optical axis is greater than or equal to 6 degrees and less than or equal to 10 degrees.

4. The package structure according to claim 2, wherein when the lens is spherical, the included angle between the normal line and the principal optical axis is greater than or equal to 2 degrees and less than or equal to 8 degrees.

5. The package structure according to any one of claims 1 to 4, wherein
an optical filter film is attached to an edge of the lens; and/or
an optical filter is disposed between the lens and the optical receiving chip, and the optical filter is located on a reflection path of the signal light on the optical receiving chip.

6. The package structure according to any one of claims 1 to 5, wherein the optical receiving chip is mounted on a bearing module having an oblique surface.

7. The package structure according to claim 6, wherein a height of the bearing module is adjustable.

8. The package structure according to any one of claims 1 to 7, wherein the optical fiber is located on the principal optical axis.

9. The package structure according to any one of claims 1 to 8, wherein an optical splitter is disposed between the ferrule and the lens, a center of the optical splitter is located on the principal optical axis, and an included angle between a straight line on which the optical fiber is located and the optical splitter is equal to an included angle between the optical splitter and the principal optical axis.

10. The package structure according to any one of claims 1 to 9, further comprising an optical emitting chip, wherein
the optical emitting chip is disposed in the accommodation cavity; or
the package structure further comprises another tube base and another tube cap, the another tube base and the another tube cap cooperate to form another accommodation cavity, and the optical emitting chip is disposed in the another accommodation cavity.

11. An optical module, comprising a processor and the package structure according to any one of claims 1 to 10.

12. The optical module according to claim 11, wherein the optical module further comprises a light source and a driver.

13. An optical communication system, comprising an electronic device and the optical module according to claim 11 or 12, wherein the electronic device is connected to the optical module, and the electronic device is any one of a switch, an optical fiber router, or an optical fiber network adapter.
